# EUROPEAN PATENT APPLICATION

(11) **EP 4 708 707 A1**
(43) Date of publication of application: **11.03.2026**
(21) Application number: 24832220.8
(22) Date of filing: 02.05.2024
(51) Int. Cl.: H04B 1/40, H03F 1/02, H03F 3/195, H04B 1/04

(54) **ELECTRONIC DEVICE FOR ADAPTIVELY CHANGING POWER SUPPLY CIRCUIT CONNECTED TO POWER AMPLIFIER FOR TRANSMISSION POWER OF SIGNAL**

(30) Priority: 27.06.2023 KR 20230083065
(71) Applicant: Samsung Electronics Co., Ltd., Suwon-si, Gyeonggi-do 16677 (KR)
(72) Inventor: MOON, Yohan, Suwon-si, Gyeonggi-do 16677 (KR); NA, Hyoseok, Suwon-si, Gyeonggi-do 16677 (KR); KANG, Hyunsang, Suwon-si, Gyeonggi-do 16677 (KR); YANG, Dongil, Suwon-si, Gyeonggi-do 16677 (KR)
(74) Representative: Gulde & Partner
(86) International application number: PCT/KR2024/005960
(87) International publication number: WO 2025/005436

(57) **Abstract**

An electronic device is provided. The electronic device may comprise a first antenna. The electronic device may comprise a second antenna. The electronic device may comprise a power supply circuit including a first power supply circuit and a second power supply circuit. The electronic device may comprise a first front end module (FEM) including a power amplifier (PA) connected to the first power supply circuit and connectable to the second power supply circuit. The electronic device may comprise a second FEM including a PA connected to the second power supply circuit and connectable to the first power supply circuit. The electronic device may comprise at least one processor including a processing circuit.

## Description

### [Technical Field]

The disclosure relates to an electronic device adaptively changing a power supply circuit connected to a power amplifier (PA) for a transmit power (Tx power) of a signal.

### [Background Art]

An electronic device may include front end modules (FEMs) to transmit or receive a signal on each of various frequencies. For example, each of the FEMs may include a power amplifier (PA) for a transmit power (Tx power) of a signal to be transmitted via each of antennas connected to each of the FEMs. The PA may obtain the Tx power based on a voltage from a power supply circuit.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is provided. The electronic device may comprise a first antenna. The electronic device may comprise a second antenna. The electronic device may comprise a power supply circuitry including a first power supply circuit and a second power supply circuit. The electronic device may comprise a first front end module (FEM) including a power amplifier (PA) connected to the first power supply circuit and connectable to the second power supply circuit. The electronic device may comprise a second FEM including a PA connected to the second power supply circuit and connectable to the first power supply circuit. The electronic device may comprise a processor. The processor may be configured to control (or cause) the power supply circuitry to disconnect the PA in the first FEM from the second power supply circuit to transmit a signal, with a transmit (Tx) power obtained by using the PA in the first FEM operating based on a voltage from the first power supply circuit, via the first antenna. The processor may be configured to control (or cause) the power supply circuitry to disconnect the PA in the second FEM from the first power supply circuit to transmit a signal, with a Tx power obtained by using the PA in the second FEM operating based on a voltage from the second power supply circuit, via the second antenna. The processor may be configured to control (or cause) the power supply circuitry to connect the PA in the second FEM to the first power supply circuit to transmit a signal, with a Tx power obtained by using the PA in the second FEM operating based on a voltage from the second power supply circuit from among the first power supply circuit and the second power supply circuit, via the second antenna.

An electronic device is provided. The electronic device may comprise a first antenna. The electronic device may comprise a second antenna. The electronic device may comprise a power supply circuitry including a first power supply circuit and a second power supply circuit. The electronic device may comprise a first front end module (FEM) including a power amplifier (PA) connected to the first power supply circuit and connectable to the second power supply circuit. The electronic device may comprise a second FEM including a PA connected to the second power supply circuit and connectable to the first power supply circuit. The electronic device may comprise a processor. The processor may be configured to transmit, by enabling the first power supply circuit that is connected to the PA in the first FEM and is disconnected from the PA in the second FEM and enabling the second power supply that is connected to the PA in the second FEM and is disconnected from the PA in the first FEM, a signal via the second antenna by using the PA in the second FEM, while a signal is transmitted via the first antenna by using the PA in the first FEM. The processor may be configured to transmit, by enabling the first power supply circuit that is connected to the PA in the first FEM and is connected to the PA in the second FEM and disabling the second power supply circuit that is connected to the PA in the first FEM and is connected to the PA in the second FEM, a signal via the second antenna by using the PA in the second FEM.

### [Description of the Drawings]

FIG. 1 illustrates an exemplary power supply module including a switch module and power supply circuits.
FIG. 2 illustrates an exemplary electronic device comprising a power supply module comprising a single pole single throw (SPST) switch and power supply circuits.
FIG. 3 illustrates an exemplary electronic device comprising a power supply module comprising two SPST switches and power supply circuits.
FIG. 4 illustrates an exemplary electronic device comprising a power supply module comprising a double pole double throw (DPDT) switch and power supply circuits.
FIG. 5 is a block diagram of an electronic device in a network environment according to various embodiments.

### [Mode for Invention]

An electronic device may include a power supply module for communication with an external electronic device. The power supply module may be included in the electronic device to provide a voltage to a power amplifier (PA) in a front end module (FEM) (or a radio frequency front end (RFFE))(or a RF circuit) of the electronic device used to obtain a transmit power (Tx power) of a signal to be transmitted to the external electronic device. For example, the power supply module may include two or more power supply circuits. For example, the power supply module may be referred to as a power supply, a power supply circuit (or power supply circuitry), a power supply integrated circuit, or a multi-core power modulator.

Each of the two or more power supply circuits may be configured to provide the voltage to the PA. The voltage may be a supply voltage (e.g., Vcc) for a dynamic range (or operation range) of the PA. For example, the voltage may be provided to the PA to obtain a Tx power of a signal to be transmitted to the external electronic device using the PA.

As a non-limiting example, the voltage may be obtained, set, or provided based on an average power tracking (APT). For example, each of the two or more power supply circuits may be an APT modulator. For example, the APT may be used to reduce unnecessary power consumption by the PA. For example, the APT may be used to change the voltage dynamically or adaptively, based on an average output power of the PA. For example, the APT may adaptively change the voltage whenever the average output voltage is changed. The APT may be used to set the voltage while a Tx power set or obtained by the PA is within a first range. For example, the APT may be used to set the voltage while the Tx power is within the first range, for example, less than or equal to 18 decibel milliwatt (dBm). However, it is not limited thereto.

As a non-limiting example, the voltage may be obtained, set, or provided based on an envelope tracking (ET). For example, each of the two or more power supply circuits may be an ET modulator. For example, the ET may be used to address high peak-to-average power ratio (PAPR) and a high average output power (and/or a wide bandwidth) in which the ATP cannot address. For example, the ET may be used to change the voltage dynamically or adaptively, based on a radio frequency (RF) modulation amplitude (e.g., an instantaneous output voltage) instead of the average output power. The ET may be used to set the voltage while a Tx power set by the PA is within a second range different from the first range. The ET may be used to set the supply voltage while the Tx power is within the second range, for example, above 18 (dBm). However, it is not limited thereto.

Each of the two or more power supply circuits may be referred to as a power modulator or a power supply.

For example, the power supply module may include a switch module (e.g., including at least one switch). For another example, the power supply module may be connected to the switch module located outside the power supply module. For example, the two or more power supply circuits may include a first power supply circuit and a second power supply circuit. For example, the first power supply circuit may include a power modulator, an ET modulator, or an APT modulator, and the second power supply circuit may include a power modulator, an ET modulator, or an APT modulator.

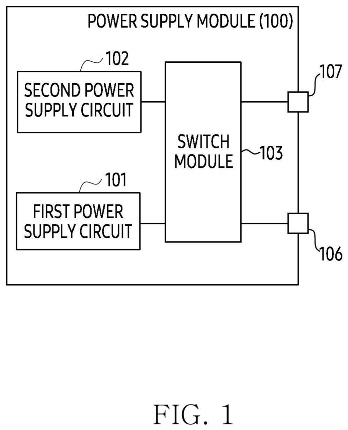

As a non-limiting example, the first power supply circuit may be connected to a PA in a first FEM, and a second power supply circuit may be connected to a PA in a second FEM. As a non-limiting example, the first power supply circuit may be connected to the PA in the second FEM, and the second power supply circuit may be connected to the PA in the first FEM. For example, the switch module may be used to connect the first power supply circuit to the PA in the second FEM or disconnect the first power supply circuit from the PA in the second FEM. For example, the switch module may be used to connect the second power supply circuit to the PA in the first FEM or disconnect the second power supply circuit from the PA in the first FEM. For example, the switch module for such connection and such disconnection may support various transmissions (illustrated and described in greater below) within a wireless environment. The power supply module including the switch module, the first power supply circuit, and the second power supply circuit may be illustrated in in greater detail below with reference to FIG. 1.

FIG. 1 illustrates an exemplary power supply module including a switch module and power supply circuits.

Referring to FIG. 1, a power supply module 100 may include a plurality of power supply circuits including a first power supply circuit 101 and a second power supply circuit 102. For example, the power supply module 100 may include a plurality of pins (or a plurality pads) (or a plurality ports) used to connect to other components of the electronic device (e.g., a plurality of FEMs). For example, the plurality of pins may include a first pin 106 (or a first pad 106) (or a first port 106) and a second pin 107 (or a second pad 107) (or a second port 107). Although not illustrated in FIG. 1, for example, the plurality of pins may be connected to a plurality of power amplifiers (PAs) in the plurality of FEMs. As a non-limiting example, the electronic device may include at least one FEM different from the plurality of FEMs. For example, at least one PA in the at least one FEM may be disconnected from the power supply module 100 and connected to a portion of the plurality of FEMs.

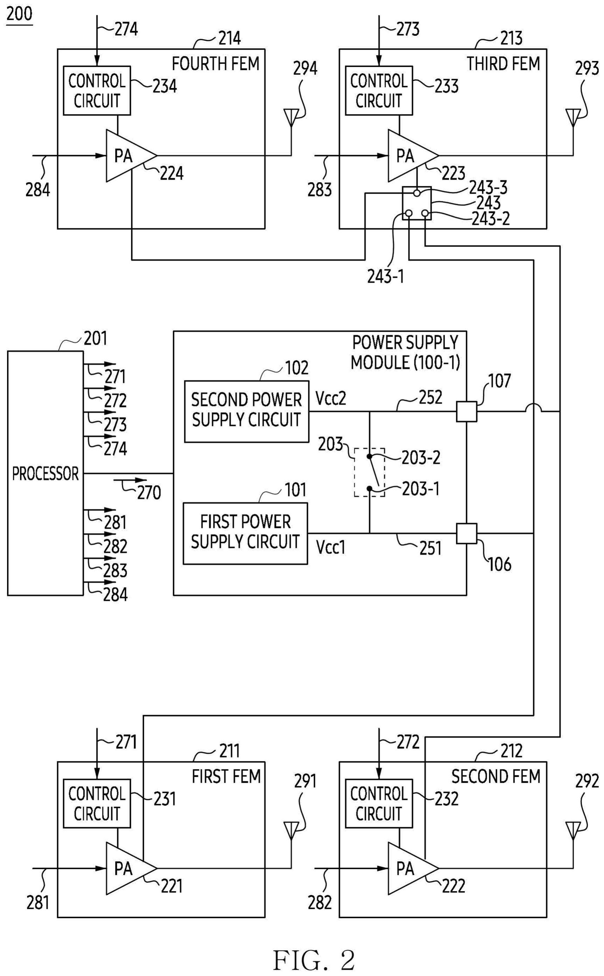

For example, the power supply module 100 may include a switch module (e.g., including at least one switch) 103. For example, the switch module 103 may be referred to as a switching circuit 103. For example, since the switch module 103 is connected to at least a part of the plurality of power supply circuits and at least a part of the pins, the switch module 103 may be used to connect at least part of the plurality of PAs to the at least part of the plurality of power supply circuits or disconnect at least part of the plurality of PAs from the at least part of the plurality of power supply circuits. For example, the switch module 103 may include at least one switch. The at least one switch will be illustrated and described in greater detail below with reference to FIGS. 2, 3 and 4.

For example, the switch module 103 may be connected to each of the first power supply circuit 101 and the second power supply circuit 102, and may be connected to the first pin 106 connected to a PA in a first FEM of the electronic device and a second pin 107 connected to a PA in a second FEM of the electronic device.

For example, the switch module 103 may be configured to connect the first power supply circuit 101 to the first pin 106 according to a control of a processor of the electronic device, in order to provide a voltage from the first power supply circuit 101 to the PA in the first FEM. For example, the switch module 103 may be configured to connect the second power supply circuit 102 to the second pin 107 according to a control of the processor, in order to provide a voltage from the second power supply circuit 102 to the PA in the second FEM. For example, the switch module 103 may be configured to connect the first power supply circuit 101 to the second pin 107 according to a control of the processor, in order to provide the voltage from the first power supply circuit 101 to the PA in the second FEM. For example, the switch module 103 may be further configured to connect the second power supply circuit 102 to the first pin 106 according to a control of the processor, in order to provide the voltage from the second power supply circuit 102 to the PA in the first FEM.

For example, the switch module 103 may be configured to disconnect the PA in the second FEM from the first power supply circuit 101 according to a control of the processor. For example, providing the voltage from the first power supply circuit 101 to the PA in the second FEM may be ceased by disconnecting the PA in the second FEM from the first power supply circuit 101. For example, the switch module 103 may be further configured to disconnect the PA in the first FEM from the second power supply circuit 102 according to a control of the processor. For example, providing the voltage from the second power supply circuit 102 to the PA in the first FEM may be ceased by disconnecting the PA in the first FEM from the second power supply circuit 102. For example, the switch module 103 may be further configured to disconnect the PA in the first FEM from the first power supply circuit 101 according to a control of the processor. For example, providing the voltage from the first power supply circuit 101 to the PA in the first FEM may be ceased by disconnecting the PA in the first FEM from the first power supply circuit 101. For example, the switch module 103 may be further configured to disconnect the PA in the second FEM from the second power supply circuit 102 according to a control of the processor. For example, providing the voltage from the second power supply circuit 102 to the PA in the second FEM may be ceased by disconnecting the PA in the second FEM from the second power supply circuit 102.

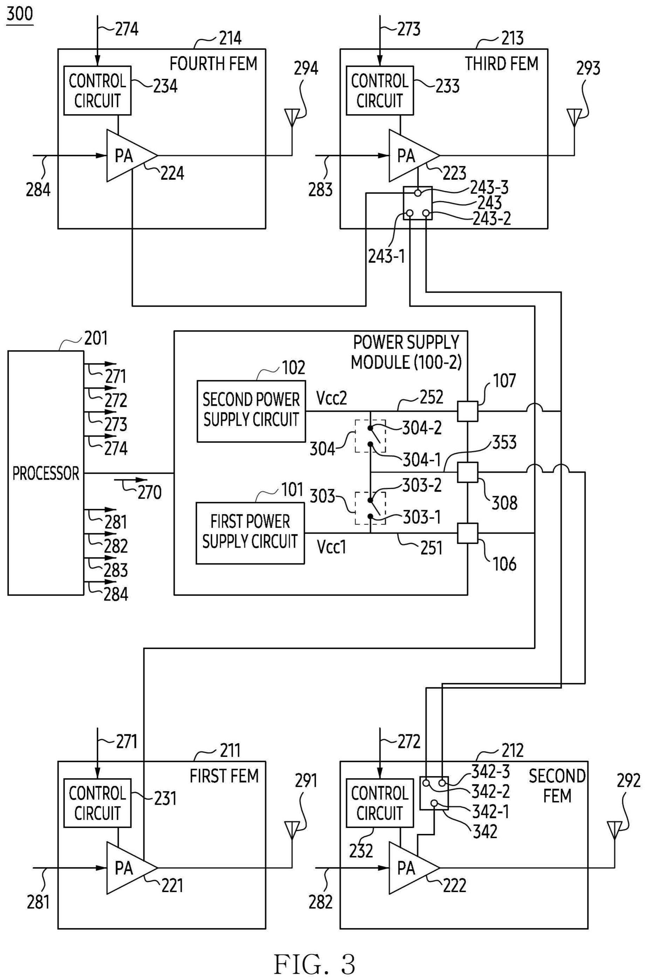

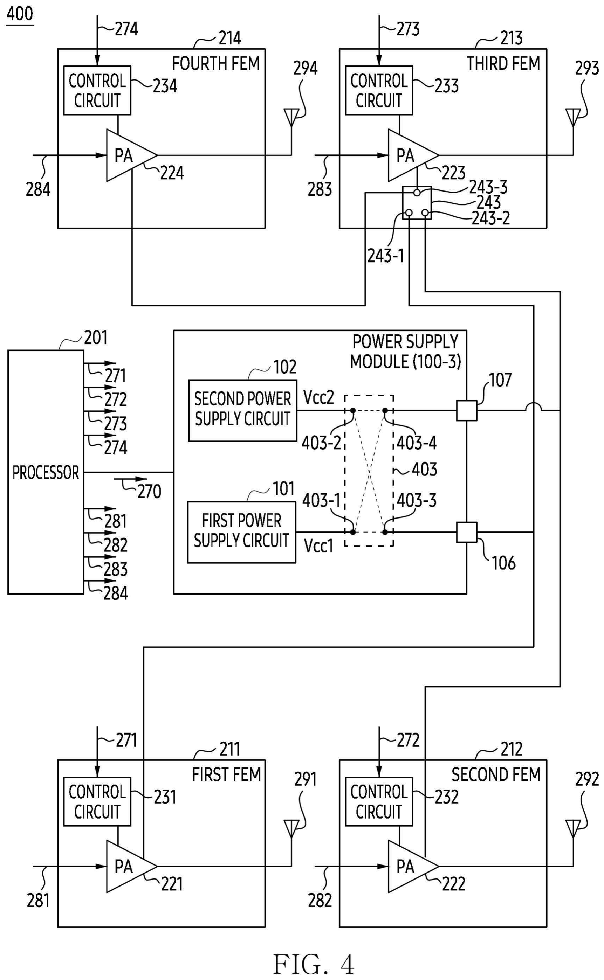

FIG. 1 illustrates an example in which the switch module 103 includes four ports (or terminals), but this is simply for convenience of explanation. The switch module 103 may be implemented in various ways. For example, the switch module 103 may be implemented with a single pole single throw (SPST) switch. A power supply module including the SPST switch may be illustrated in description of FIG. 2. As another example, the switch module 103 may be implemented with two SPST switches. A power supply module including the two SPST switches may be illustrated in description of FIG. 3. As still another example, the switch module 103 may be implemented with a double pole double throw (DPDT) switch. A power supply module including the DPDT switch may be illustrated in description of FIG. 4.

FIG. 2 illustrates an exemplary electronic device comprising a power supply module comprising a single pole single throw (SPST) switch and power supply circuits.

Referring to FIG. 2, an electronic device 200 may, for example, and without limitation, be one of various types of mobile devices, such as smartphones (e.g., a bar-type smartphone, a foldable-type smartphone, or a rollable-type smartphone) with various form factors, a tablet, a wearable device, a laptop computer, a cellular phone, and other similar computing devices. Components illustrated in FIG. 2, relationships thereof, and functions thereof are exemplary only, and do not limit implementations described or claimed in this disclosure. The electronic device 200 may be referred to as a user device or a multifunctional device.

According to an embodiment, the electronic device 200 may include components including a processor (e.g., including processing circuitry) 201, a power supply module (e.g., including power supply circuitry) 100-1, a first FEM 211, a second FEM 212, a third FEM 213, a fourth FEM 214, a first antenna 291, a second antenna 292, a third antenna 293, and/or a fourth antenna 294. The components are merely exemplary. For example, the electronic device 200 may include another component (e.g., a power management integrated circuit (PMIC), an audio processing circuit, an input/output (IO) interface, or memory comprising one or more storage mediums (or devices) and storing instructions executable by the processor 201). For example, some components (e.g., the third FEM 213, the fourth FEM 214, the third antenna 293, and the fourth antenna 294) may be omitted from the electronic device 200.

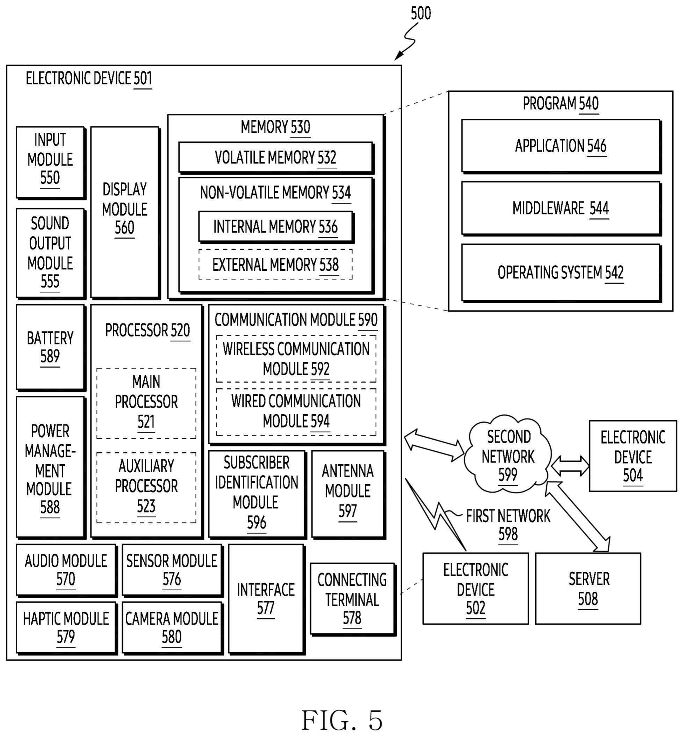

The processor 201 may include one or more processing circuits. The processor 201 =may, for example, include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. For example, the processor 201 may be implemented with one or more integrated circuit (IC) chips and may execute various data processing. For example, the processor 201 may be implemented with a system in chip (SoC) (e.g., one chip or chipset). For example, the processor 201 may include subcomponents including a central processing unit (CPU), a graphics processing unit (GPU), a neural processing unit (NPU), an image signal processor (ISP), a display controller, a memory controller, a storage controller, a communication processor (CP), and/or a sensor interface. The subcomponents are exemplary only. For example, the processor 201 may further include other subcomponents. For example, some subcomponents may be omitted from the processor 201. For example, the processor 201 may include at least part of a processor 520 of FIG. 5 or may correspond to at least part of the processor 520 of FIG. 5.

For example, the processor 201 may generate or obtain one or more signals (e.g., a signal 281, a signal 282, a signal 283, and/or a signal 284) to be transmitted via at least a part of a plurality of antennas including the first antenna 291 to the fourth antenna 294. For example, the one or more signals may be provided from the processor 201 to at least a part of a plurality of FEMs including the first FEM 211 to the fourth FEM 214. For example, the one or more signals may be provided from the processor 201 to the at least a part of the plurality of FEMs via at least one other component (e.g., a radio frequency integrated circuit (RFIC)) of the electronic device 200.

For example, the processor 201 may provide a control signal 270 to the power supply module 100-1 to control or cause the power supply module 100-1. For example, the processor 201 may provide the control signal 271 to the first FEM 211 (or a control circuit 231 of the first FEM 211) to control or cause the first FEM 211. For example, the processor 201 may provide a control signal 272 to the second FEM 212 (or a control circuit 232 of the second FEM 212) to control or cause the second FEM 212. For example, the processor 201 may provide a control signal 273 to the third FEM 213 (or a control circuit 233 of the third FEM 213) to control or cause the third FEM 213. For example, the processor 201 may provide a control signal 274 to the fourth FEM 214 (or a control circuit 234 of the fourth FEM 214) to control or cause the fourth FEM 214. As a non-limiting example, the control signal 271 to the control signal 274 may be implemented as a (or single) control signal.

For example, the power supply module 100-1 may include a first power supply circuit 101, a second power supply circuit 102, a switch 203, which is a switch module 103 implemented as an SPST switch, a first pin 106 connected to a PA 221, and a second pin 107 connected to a PA 222. For example, the switch 203 may include a first terminal 203-1 connected to a first path 251 from the first power supply circuit 101 to the first pin 106 and a second terminal 203-2 connected to a second path 252 from the second power supply circuit 102 to the second pin 107. For example, the switch 203 may be in a first state of disconnecting the first terminal 203-1 from the second terminal 203-2 or in a second state of connecting the first terminal 203-1 to the second terminal 203-2.

For example, each of the plurality of FEMs including the first FEM 211 to the fourth FEM 214 may include a PA and a control circuit. For example, the first FEM 211 may include a PA 221 and a control circuit 231, the second FEM 212 may include a PA 222 and a control circuit 232, the third FEM 213 may include a PA 223 and a control circuit 233, and the fourth FEM 214 may include a PA 224 and a control circuit 234. For example, the third FEM 213 may further include a switch 243.

For example, the first FEM 211 may be used to transmit and receive a signal 281 on a frequency lower than 1 gigahertz (GHz) via the first antenna 291, the second FEM 212 may be used to transmit and receive a signal 282 on a frequency higher than or equal to 1 GHz and lower than 7.125 GHz via the second antenna 292, the third FEM 213 may be used to transmit and receive a signal 283 on a frequency higher than or equal to 24 GHz and lower than 71 GHz via the third antenna 293, and the fourth FEM 214 may be used to transmit and receive a signal 284 on a frequency lower than 2.3 GHz via the fourth antenna 294.

For example, the PA 221 may be electrically connectable to the first power supply circuit 101. For example, the PA 221 may be electrically connectable to the second power supply circuit 102 via the switch 203. For example, a connection between the first power supply circuit 101 and the PA 221 may be maintained independently of (or regardless of) whether the PA 221 is connected to the second power supply circuit 102.

For example, the PA 222 may be electrically connected to the second power supply circuit 102. For example, the PA 222 may be electrically connected to the first power supply circuit 101 via the switch 203. For example, a connection between the second power supply circuit 102 and the PA 222 may be maintained independently of (or regardless of) whether the PA 222 is connected to the first power supply circuit 101.

For example, the processor 201 may control the power supply module 100-1 to disconnect the PA 221 from the second power supply circuit 102, in order to transmit the signal 281, via the first antenna 291, with a Tx power obtained using the PA 221 operating based on a voltage Vcc1 from the first power supply circuit 101. For example, the processor 201 may not electrically connect the PA 221 from the second power supply circuit 102 by disconnecting the first terminal 203-1 of the switch 203 and the second terminal 203-2 of the switch 203 based on providing a control signal 270 indicating the first state to the power supply module 100-1.

For example, the processor 201 may control the power supply module 100-1 to disconnect the PA 222 from the first power supply circuit 101, in order to transmit the signal 282, via the second antenna 292, with a Tx power obtained using the PA 222 operating based on a voltage Vcc2 from the second power supply circuit 102. For example, the processor 201 may not electrically connect the PA 222 from the first power supply circuit 101, by disconnecting the second terminal 203-2 of the switch 203 and the first terminal 203-1 of the switch 203 based on providing the control signal 270 indicating the first state to the power supply module 100-1.

For example, since the second power supply circuit 102 is disconnected from the PA 221 and the first power supply circuit 101 is disconnected from the PA 222 by disconnecting the second terminal 203-2 of the switch 203 from the first terminal 203-1 of the switch 203, the signal 281 may be transmitted via the first antenna 291 while the signal 282 is transmitted. For example, the electronic device 200 may support dual connectivity (e.g., evolved universal mobile telecommunication system (UMTS) terrestrial radio access (E-UTRA) new radio (NR) dual connectivity (DC) (EN-DC) and/or NR E-UTRA DC (NE-DC)), by including the power supply module 100-1 including the switch 203.

For example, since the second power supply circuit 102 is disconnected from the PA 221 and the first power supply circuit 101 is disconnected from the PA 222 as the second terminal 203-2 of the switch 203 is disconnected from the first terminal 203-1 of the switch 203, the signal 284 may be transmitted via the fourth antenna 294 while the signal 281 (or signal 282) is transmitted.

For example, the processor 201 may provide a control signal 273 indicating connecting the second terminal 243-2 of the switch 243 to the third terminal 243-3 of the switch 243 and disconnecting the first terminal 243-1 of the switch 243 from the third terminal 243-3 of the switch 243 to the control circuit 233, in order to transmit the signal 284 while the signal 281 is transmitted. For example, the voltage Vcc2 from the second power supply circuit 102 may be provided to the PA 224, via the switch 243 in a state of connecting the second terminal 243-2 of the switch 243 to the third terminal 243-3 of the switch 243 and disconnecting the first terminal 243-1 of the switch 243 from the third terminal 243-3 of the switch 243. For example, while the signal 281 is transmitted, the signal 284 may be transmitted via the fourth antenna 294 with a Tx power obtained using the PA 224 operating based on the voltage Vcc2 from the second power supply circuit 102. For example, transmitting the signal 282 may be disabled while the signal 281 and the signal 284 are transmitted.

For example, in order to transmit the signal 284 while the signal 282 is transmitted, the processor 201 may provide control circuit 233 with the control signal 273 indicating connecting the first terminal 243-1 of the switch 243 to the third terminal 243-3 of the switch 243 and disconnecting the second terminal 243-2 of the switch 243 from the third terminal 243-3 of the switch 243. For example, the voltage Vcc1 from the first power supply circuit 101 may be provided to the PA 224 via the switch 243 in a state of connecting the first terminal 243-1 of the switch 243 to the third terminal 243-3 of the switch 243 and disconnecting the second terminal 243-2 of the switch 243 from the third terminal 243-3 of the switch 243. For example, while the signal 282 is transmitted, the signal 284 may be transmitted via the fourth antenna 294 with a Tx power obtained using the PA 224 operating based on the voltage Vcc1 from the first power supply circuit 101. For example, transmitting signal 281 may be disabled while the signal 282 and the signal 284 are transmitted.

For example, in order to transmit the signal 282 via the second antenna 292 with a Tx power obtained using the PA 222 operating based on the voltage Vcc1 from the first power supply circuit 101 from among the first power supply circuit 101 and the second power supply circuit 102, the processor 201 may control the power supply module 100-1 to electrically connect the PA 222 to the first power supply circuit 101. For example, the processor 201 may electrically connect the PA 222 to the first power supply circuit 101, by connecting the second terminal 203-2 of the switch 203 to the first terminal 203-1 of the switch 203 based on providing the control signal 270 indicating the second state to the power supply module 100-1.

For example, the processor 201 may disable transmitting the signal 281 via the first antenna 291, while the second terminal 203-2 is connected to the first terminal 203-1 and the signal 282 is transmitted via the second antenna 292 based on the voltage Vcc1 from the first power supply circuit 101 from among the first power supply circuit 101 and the second power supply circuit 102. For example, the processor 201 may disable transmitting the signal 281 via the first antenna 291, by ceasing (or refraining from) obtaining (or generating) the signal 281 or by ceasing refraining (or refraining from) providing the signal 281 to the PA 221. For example, the processor 201 may disable transmitting the signal 281 via the first antenna 291, by providing the control circuit 231 with the control signal 271 indicating disabling the PA 221.

For example, when the electronic device 200 further includes the third FEM 213, the fourth FEM 214, the third antenna 293, and the fourth antenna 294, the processor 201 may disable transmitting the signal 283 via the third antenna 293 using the third FEM 213 and transmitting the signal 284 via the fourth antenna 294 using the fourth FEM 214 while the second terminal 203-2 is connected to the first terminal 203-1 and the signal 282 is transmitted via the second antenna 292 based on the voltage Vcc1 from the first power supply circuit 101 from among the first power supply circuit 101 and the second power supply circuit 102. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disconnecting the first terminal 243-1 (or the first terminal 243-1 and the second terminal 243-2) of the switch 243 from the third terminal 243-3 of the switch 243. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disabling the PA 223 and the control circuit 234 with the control signal 274 indicating disabling the PA 224. For example, the processor 201 may disable transmitting the signal 283 via the third antenna 293 using the third FEM 213 and transmitting the signal 284 via the fourth antenna 294 using the fourth FEM 214, by refraining from obtaining each of the signals 283 and 284, or refraining from providing each of the signals 283 and 284 to each of the third FEM 213 and the fourth FEM 214.

For example, the processor 201 may control or cause the power supply module 100-1 to disable the second power supply circuit 102, while the second terminal 203-2 is connected to the first terminal 203-1 and the signal 282 is transmitted via the second antenna 292 based on the voltage Vcc1 from the first power supply circuit 101 from among the first power supply circuit 101 and the second power supply circuit 102. For example, the processor 201 may control the power supply module 100-1 to disable the second power supply circuit 102, by providing the power supply module 100-1 with the control signal 270 indicating turning off the second power supply circuit 102.

As a non-limiting example, a capability of the first power supply circuit 101 may be different from a capability of the second power supply circuit 102. For example, the first power supply circuit 101 may be an ET modulator that supports both providing a voltage Vcc1 based on the ET and providing a voltage Vcc1 based on the APT, and the second power supply circuit 102 may be an APT modulator that supports only providing a voltage Vcc2 based on the APT. For example, a bandwidth of a signal transmitted using the first power supply circuit 101 may be wider than a bandwidth of a signal transmitted using the second power supply circuit 102. For example, a maximum Tx power capable of being obtained using the first power supply circuit 101 may be higher than a maximum Tx power capable of being obtained using the second power supply circuit 102. For example, by including the power supply module 100-1 including the switch 203, the electronic device 200 may obtain a Tx power higher than the Tx power obtained using the PA 222 based on the voltage Vcc2, using the PA 222 based on the voltage Vcc1. For example, the electronic device 200 may provide diversity of Tx power, by including the power supply module 100-1 including the switch 203.

As a non-limiting example, since the PA 222 not only obtains the voltage Vcc2 from the second power supply circuit 102 but also obtains the voltage Vcc1 from the first power supply circuit 101, the electronic device 200 may transmit the signal 282 via the second antenna 292 even when a path from the second power supply circuit 102 to the PA 222 is at least partially damaged.

For example, the processor 201 may control the power supply module 100-1 to connect the PA 221 to the second power supply circuit 102, in order to transmit the signal 281 via the first antenna 291 with a Tx power obtained using the PA 221 operating based on the voltage Vcc2 from the second power supply circuit 102 from among the first power supply circuit 101 and the second power supply circuit 102. For example, the processor 201 may connect the PA 221 to the second power supply circuit 102, by connecting the second terminal 203-2 of the switch 203 to the first terminal 203-1 of the switch 203 based on providing the power supply module 100-1 with the control signal 270 indicating the second state.

For example, the processor 201 may disable transmitting the signal 282 via second antenna 292, while the second terminal 203-2 is connected to the first terminal 203-1 and the signal 281 is transmitted via the first antenna 291 based on the voltage Vcc2 from the second power supply circuit 102 from among the first power supply circuit 101 and the second power supply circuit 102. For example, the processor 201 may disable transmitting the signal 282 via the second antenna 292, by ceasing (or refraining from) obtaining (or generating) the signal 282, or ceasing (or refraining from) providing the signal 282 to the PA 222. For example, the processor 201 may disable transmitting the signal 282 via the second antenna 292, by providing the control circuit 232 with the control signal 272 indicating disabling the PA 222.

For example, when the electronic device 200 further includes the third FEM 213, the fourth FEM 214, the third antenna 293, and the fourth antenna 294, the processor 201 may disable transmitting the signal 283 via the third antenna 293 using the third FEM 213 and transmitting the signal 284 via the fourth antenna 294 using the fourth FEM 214, while the second terminal 203-2 is connected to the first terminal 203-1 and the signal 281 is transmitted via the first antenna 291 based on the voltage Vcc2 from the second power supply circuit 102 from among the first power supply circuit 101 and the second power supply circuit 102. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disconnecting the first terminal 243-1 and the second terminal 243-2 of the switch 243 from the third terminal 243-3 of the switch 243. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disabling the PA 223 and the control circuit 234 with the control signal 274 indicating disabling the PA 224. For example, the processor 201 may disable transmitting the signal 283 via the third antenna 293 using the third FEM 213 and transmitting the signal 284 via the fourth antenna 294 using the fourth FEM 214, by refraining from obtaining each of the signal 283 and the signal 284 or refraining from providing each of the signal 283 and the signal 284 to each of the third FEM 213 and the fourth FEM 214.

For example, while the second terminal 203-2 is connected to the first terminal 203-1 and the signal 281 is transmitted via the first antenna 291 based on the voltage Vcc2 from the second power supply circuit 102 from among the first power supply circuit 101 and the second power supply circuit 102, the processor 201 may control or cause the power supply module 100-1 to disable the first power supply circuit 101. For example, the processor 201 may control the power supply module 100-1 to disable the first power supply circuit 101, by providing the power supply module 100-1 with the control signal 270 indicating turning off the first power supply circuit 101.

As a non-limiting example, since the PA 221 not only obtains the voltage Vcc1 from the first power supply circuit 101 but also obtains the voltage Vcc2 from the second power supply circuit 102, the electronic device 200 may transmit the signal 281 via the first antenna 291 even when a path from the first power supply circuit 101 to the PA 221 is at least partially damaged.

For example, the processor 201 may control the power supply module 100-1 to connect the PA 222 to the first power supply circuit 101 and the second power supply circuit 102, in order to transmit the signal 282 with the Tx power obtained using the PA 222 operating based on the voltage Vcc1 from the first power supply circuit 101 and the voltage Vcc2 from the second power supply circuit 102 equal to the voltage Vcc1 (or a voltage from the first power supply circuit 101 and the second power supply circuit 102), via the second antenna 292. For example, the processor 201 may connect the second terminal 203-2 of the switch 203 to the first terminal 203-1 of the switch 203 and enable both the first power supply circuit 101 and the second power supply circuit 102, based on providing the power supply module 100-1 with the control signal 270 indicating the second state and indicating enabling both the first power supply circuit 101 and the second power supply circuit 102.

For example, while the second terminal 203-2 is connected to the first terminal 203-1 and the signal 282 is transmitted via the second antenna 292 based on the voltage from the first power supply circuit 101 and the second power supply circuit 102, the processor 201 may disable transmitting the signal 281 via the first antenna 291. For example, the processor 201 may disable transmitting the signal 281 via the first antenna 291, by ceasing (or refraining from) obtaining (or generating) the signal 281 or ceasing (or refraining from) providing the signal 281 to the PA 221. For example, the processor 201 may disable transmitting the signal 281 via the first antenna 291 by providing the control circuit 231 with the control signal 271 indicating disabling the PA 221.

For example, when the electronic device 200 further includes the third FEM 213, the fourth FEM 214, the third antenna 293, and the fourth antenna 294, the processor 201 may disable transmitting the signal 283 via the third antenna 293 using the third FEM 213 and transmitting the signal 284 via the fourth antenna 294 using the fourth FEM 214, while the second terminal 203-2 is connected to the first terminal 203-1 and the signal 282 is transmitted via the second antenna 292 based on the voltage from both the first power supply circuit 101 and the second power supply circuit 102. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disconnecting the first terminal 243-1 of the switch 243 from the third terminal 243-3 of the switch 243 and disconnecting the second terminal 243-2 of the switch 243 from the third terminal 243-3 of the switch 243. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disabling the PA 223 and the control circuit 234 with the control signal 274 indicating disabling the PA 224. For example, the processor 201 may disable transmitting the signal 283 via the third antenna 293 using the third FEM 213 and transmitting the signal 284 via the fourth antenna 294 using the fourth FEM 214, by refraining from obtaining each of the signal 283 and the signal 284 or refraining from providing each of the signal 283 and the signal 284 to each of the third FEM 213 and the fourth FEM 214.

As a non-limiting example, a Tx power of the signal 282 transmitted via the second antenna 292 using both the first power supply circuit 101 and the second power supply circuit 102 may correspond to power class 2 (e.g., 26 dBm (tolerance: +2/-3 dBm) or power class 1.5 (e.g., 29 dBm (tolerance: +2/-3 dBm) of the communication standard. For example, since an intensity of a current used (or consumed) to obtain a Tx power corresponding to the power class 2 or the power class 1.5 is higher than a maximum intensity of a current capable of being obtained from a (or any one of) power supply circuit from among the first power supply circuit 101 and the second power supply circuit 102, the processor 201 may connect both the first power supply circuit 101 and the second power supply circuit 102 in parallel to the PA 222 using the switch 203.

As a non-limiting example, when the signal 282 is transmitted to a satellite via the second antenna 292 using both the first power supply circuit 101 and the second power supply circuit 102, an intensity of a current used to obtain a Tx power of the signal 282 may be higher than a maximum intensity of a current capable of being obtained from a (or any one of) power supply circuit from among the first power supply circuit 101 and the second power supply circuit 102. For example, the processor 201 may electrically connect both the first power supply circuit 101 and the second power supply circuit 102 to the PA 222 in parallel using the switch 203, in order to obtain the Tx power of the signal 282. For example, the electronic device 200 may transmit a signal with a higher Tx power by including the power supply module 100-1 including the switch 203.

For example, in order to transmit the signal 281 with a Tx power obtained using the PA 221 operating based on the voltage Vcc1 from the first power supply circuit 101 and the voltage Vcc2 from the second power supply circuit 102 equal to the voltage Vcc1 (or a voltage from the first power supply circuit 101 and the second power supply circuit 102) via the first antenna 291, the processor 201 may control the power supply module 100-1 to connect the PA 222 to the first power supply circuit 101 and the second power supply circuit 102. For example, the processor 201 may connect the second terminal 203-2 of the switch 203 to the first terminal 203-1 of the switch 203 and enable both the first power supply circuit 101 and the second power supply circuit 102, based on providing the power supply module 100-1 with the control signal 270 indicating the second state and indicating enabling both the first power supply circuit 101 and the second power supply circuit 102.

For example, the processor 201 may disable transmitting the signal 282 via the second antenna 292, while the second terminal 203-2 is connected to the first terminal 203-1 and the signal 281 is transmitted via the first antenna 291 based on the voltage from the first power supply circuit 101 and the second power supply circuit 102. For example, the processor 201 may disable transmitting the signal 282 via the second antenna 292, by ceasing (or refraining from) obtaining (or generating) the signal 282 or ceasing (or refraining from) providing the signal 282 to the PA 222. For example, the processor 201 may disable transmitting the signal 282 via the second antenna 292, by providing the control circuit 232 with the control signal 272 indicating disabling the PA 222.

For example, when the electronic device 200 further includes the third FEM 213, the fourth FEM 214, the third antenna 293, and the fourth antenna 294, the processor 201 may disable transmitting the signal 283 via the third antenna 293 using the third FEM 213 and transmitting the signal 284 via the fourth antenna 294 using the fourth FEM 214, while the second terminal 203-2 is connected to the first terminal 203-1 and the signal 282 is transmitted via the second antenna 292 based on the voltage from both the first power supply circuit 101 and the second power supply circuit 102. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disconnecting the first terminal 243-1 of the switch 243 from the third terminal 243-3 of the switch 243 and disconnecting the second terminal 243-2 of the switch 243 from the third terminal 243-3 of the switch 243. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disabling the PA 223 and the control circuit 234 with the control signal 274 indicating disabling the PA 224. For example, the processor 201 may disable transmitting the signal 283 via the third antenna 293 using the third FEM 213 and transmitting the signal 284 via the fourth antenna 294 using the fourth FEM 214, by refraining from obtaining each of the signal 283 and the signal 284 or refraining from providing each of the signal 283 and the signal 284 to each of the third FEM 213 and the fourth FEM 214.

As a non-limiting example, a Tx power of the signal 281 transmitted via the first antenna 291 using both the first power supply circuit 101 and the second power supply circuit 102 may correspond to the power class 2 (e.g., 26 dBm (tolerance: +2/-3 dBm) or the power class 1.5 (e.g., 29 dBm (tolerance: +2/-3 dBm) of the communication standard. For example, since an intensity of a current used (or consumed) to obtain a Tx power corresponding to the power class 2 or the power class 1.5 is higher than a maximum intensity of a current capable of being obtained from a (or any one of) power supply circuit from among the first power supply circuit 101 and the second power supply circuit 102, the processor 201 may electrically connect both the first power supply circuit 101 and the second power supply circuit 102 in parallel to the PA 221 using the switch 203.

As a non-limiting example, when the signal 281 is transmitted to a satellite via the first antenna 291 using both the first power supply circuit 101 and the second power supply circuit 102, an intensity of a current used to obtain a Tx power of the signal 281 may be higher than a maximum intensity of a current capable of being obtained from a (or any one of) power supply circuit from among the first power supply circuit 101 and the second power supply circuit 102. For example, the processor 201 may connect both the first power supply circuit 101 and the second power supply circuit 102 in parallel to the PA 221 using the switch 203, in order to obtain the Tx power of the signal 281. For example, the electronic device 200 may transmit a signal with a higher Tx power, by including the power supply module 100-1 including the switch 203.

As described above, the electronic device 200 may provide transmission according to a double connection, transmission of a signal with a higher Tx power, and diversity of Tx power, using the power supply module 100-1 including the switch 203.

FIG. 2 illustrates an example in which the switch 203 is located in the power supply module 100-1, but the switch 203 may be located outside the power supply module 100-1. For example, the first terminal 203-1 of the switch 203 located outside the power supply module 100-1 may be connected to the first pin 106, and the second terminal 203-2 of the switch 203 located outside the power supply module 100-1 may be connected to the second pin 107. For example, the processor 201 may control the switch 203 located outside the power supply module 100-1 according to operations illustrated above.

FIG. 3 illustrates an exemplary electronic device comprising a power supply module comprising two SPST switches and power supply circuits.

Referring to FIG. 3, an electronic device 300 may include a power supply module 100-2 including a first pin 106, a second pin 107, a third pin 308, a first power supply circuit 101, a second power supply circuit 102, a switch 303, and a switch 304, instead of a power supply module 100-1 including a switch 203, a first pin 106, a second pin 107, a first power supply circuit 101, and a second power supply circuit 102. For example, the switch 303 and the switch 304 may be included in a switch module 103. For example, the electronic device 300 may include a second FEM 212 further including a switch 342.

For example, the second pin 107 of the power supply module 100-2 may be connected to a second terminal 342-2 of the switch 342, unlike the second pin 107 of the power supply module 100-1. For example, the third pin 308 of the power supply module 100-2 may be connected to a third terminal 342-3 of the switch 342.

For example, the switch 303 of the power supply module 100-2 may include a first terminal 303-1 connected to a first path 251 from the first power supply circuit 101 to the first pin 106 and a second terminal 303-2 connected to a first terminal 304-1 (or connected to a third path 353) of the switch 304. For example, the switch 303 may be in a first state of disconnecting the second terminal 303-2 from the first terminal 303-1 or in a second state of connecting the second terminal 303-2 to the first terminal 303-1.

For example, the switch 304 of the power supply module 100-2 may include the first terminal 304-1 (or connected to the third path 353) connected to the second terminal 303-2 of the switch 303 and the second terminal 304-2 connected to a second path 252 from the second power supply circuit 102 to the second pin 107. For example, the switch 304 may be in a first state of disconnecting the second terminal 304-2 from the first terminal 304-1 or in a second state of connecting the second terminal 304-2 to the first terminal 304-1.

For example, a PA 221 may be connected to the first power supply circuit 101.

For example, the PA 222 may be electrically connected to the second power supply circuit 102 via a switch 324. For example, the PA 222 may be electrically connected to the first power supply circuit 101 via the switch 303 and the switch 342. For example, the PA 222 may be electrically connected to both the first power supply circuit 101 and the second power supply circuit 102 via the switch 303, the switch 304, and the switch 342.

For example, the processor 201 may transmit a signal 281 with a Tx power obtained using the PA 221 operating based on a voltage Vcc1 from the first power supply circuit 101 via the first antenna 291.

For example, the processor 201 may control the switch 342 to transmit a signal 282 with a Tx power obtained using the PA 222 operating based on a voltage Vcc2 from the second power supply circuit 102 via the second antenna 292. For example, the processor 201 may transmit the signal 282 via the second antenna 292, based on connecting the second terminal 342-2 to the first terminal 342-1 and providing a control circuit 232 with a control signal 272 indicating disconnecting the third terminal 342-3 from the first terminal 342-1.

For example, the signal 282 may be transmitted while the signal 281 is transmitted. The electronic device 300 may support a double connection.

For example, a signal 284 may be transmitted while the signal 281 is transmitted. For example, the processor 201 may provide a control circuit 233 with a control signal 273 indicating connecting a second terminal 243-2 of a switch 243 to a third terminal 243-3 of the switch 243 and disconnecting a first terminal 243-1 of the switch 243 from the third terminal 243-3 of the switch 243, in order to transmit the signal 284 while the signal 281 is transmitted. For example, the voltage Vcc2 from the second power supply circuit 102 may be provided to a PA 224 via the switch 243 in a state of connecting the second terminal 243-2 of the switch 243 to the third terminal 243-3 of the switch 243 and disconnecting the first terminal 243-1 of the switch 243 from the third terminal 243-3 of the switch 243. For example, the signal 284 may be transmitted via a fourth antenna 294 with a Tx power obtained using the PA 224 operating based on the voltage Vcc2 from the second power supply circuit 102, while the signal 281 is transmitted. For example, transmitting the signal 282 may be disabled while the signal 281 and signal the 284 are transmitted.

For example, the signal 284 may be transmitted while the signal 282 is transmitted. For example, in order to transmit the signal 284 while the signal 282 is transmitted, the processor 201 may provide the control circuit 233 with the control signal 273 indicating connecting the first terminal 243-1 of the switch 243 to the third terminal 243-3 of the switch 243 and disconnecting the second terminal 243-2 of the switch 243 from the third terminal 243-3 of the switch 243. For example, the voltage Vcc1 from the first power supply circuit 101 may be provided to the PA 224 via the switch 243 in a state of connecting the first terminal 243-1 of the switch 243 to the third terminal 243-3 of the switch 243 and disconnecting the second terminal 243-2 of the switch 243 from the third terminal 243-3 of the switch 243. For example, while the signal 282 is transmitted, the signal 284 may be transmitted via the fourth antenna 294 with a Tx power obtained using the PA 224 operating based on the voltage Vcc1 from the first power supply circuit 101. For example, transmitting the signal 281 may be disabled while the signal 282 and the signal 284 are transmitted.

For example, in order to transmit the signal 282 via the second antenna 292 with a Tx power obtained using the PA 222 operating based on the voltage Vcc1 from the first power supply circuit 101 from among the first power supply circuit 101 and the second power supply circuit 102, the processor 201 may control the power supply module 100-2 and the second FEM 212 to electrically connect the PA 222 to the first power supply circuit 101. For example, the processor 201 may electrically connect the PA 222 to the first power supply circuit 101, by connecting the second terminal 303-2 of the switch 303 to the first terminal 303-1 of the switch 303 based on providing the power supply module 100-2 with a control signal 270 indicating connecting the second terminal 303-2 to the first terminal 303-1, and connecting the third terminal 342-3 to the first terminal 342-1 based on providing the control circuit 232 with a control signal 272 indicating connecting the third terminal 342-3 to the first terminal 342-1.

For example, the processor 201 may disable transmitting the signal 281 through the first antenna 291 while the signal 282 is transmitted via the second antenna 292 based on the voltage Vcc1. For example, the processor 201 may disable transmitting the signal 281 via the first antenna 291, by ceasing (or refraining from) obtaining (or generating) the signal 281 or ceasing (or refraining from) providing the signals 281 to the PA 221. For example, the processor 201 may disable transmitting the signal 281 via the first antenna 291, by providing the control circuit 231 with a control signal 271 indicating disabling the PA 221.

For example, when the electronic device 200 further includes a third FEM 213, a fourth FEM 214, a third antenna 293, and a fourth antenna 294, the processor 201 may transmit a signal 283 via the third antenna 293 using the third FEM 213 or a signal 284 via the fourth antenna 294 using the fourth FEM 214, while the signal 282 is transmitted via the second antenna 292 based on the voltage Vcc1. For example, the processor 201 may transmit the signal 283 (or the signal 284) via the third antenna 293 (or the fourth antenna 294) with a Tx power obtained by the PA 223 (or the PA 224) operating based on the voltage Vcc2 from the second power supply circuit 102, by providing to the control circuit 233 with a control signal 273 indicating connecting the second terminal 243-2 to the third terminal 243-3 and disconnecting the first terminal 243-1 from the third terminal 243-3, while the signal 282 is transmitted via the second antenna 292 based on the voltage Vcc1. For example, since the power supply module 100-2 includes two switches (e.g., the switch 303 and the switch 304) unlike the power supply module 100-1, the power supply module 100-2 may transmit the signal 283 (or the signal 284), while the signal 282 is transmitted based on the voltage Vcc1.

As a non-limiting example, a capability of the first power supply circuit 101 may be different from a capability of the second power supply circuit 102. For example, the first power supply circuit 101 may be an ET modulator that supports both providing the voltage Vcc1 based on the ET and providing the voltage Vcc1 based on the APT, and the second power supply circuit 102 may be an APT modulator that supports only providing the voltage Vcc2 based on the APT. For example, a bandwidth of a signal transmitted using the first power supply circuit 101 may be wider than a bandwidth of a signal transmitted using the second power supply circuit 102. For example, a maximum Tx power capable of being obtained using the first power supply circuit 101 may be higher than a maximum Tx power capable of being obtained using the second power supply circuit 102. For example, by including the power supply module 100-2 including the switch 303 and the switch 304, the electronic device 300 may obtain a Tx power higher than the Tx power obtained using the PA 222 based on the voltage Vcc2 using the PA 222 based on the voltage Vcc1. For example, the electronic device 300 may provide diversity of Tx power, by including the power supply module 100-2 including the switch 303 and the switch 304.

As a non-limiting example, since the PA 222 not only obtains the voltage Vcc2 from the second power supply circuit 102 but also obtains the voltage Vcc1 from the first power supply circuit 101, the electronic device 200 may transmit the signal 282 via the second antenna 292 even when a path from the second power supply circuit 102 to the PA 222 is at least partially damaged.

For example, in order to transmit the signal 282 with a Tx power obtained using the PA 222 operating based on the voltage Vcc1 from the first power supply circuit 101 and the voltage Vcc2 from the second power supply circuit 102 equal to the voltage Vcc1 (or a voltage from the first power supply circuit 101 and the second power supply circuit 102) via the second antenna 292, the processor 201 may control the power supply module 100-2 and the second FEM 212 to electrically connect the PA 222 to the first power supply circuit 101 and the second power supply circuit 102. For example, the processor 201 may connect the PA 222 to both the first power supply circuit 101 and the second power supply circuit 102, based on providing and providing the power supply module 100-2 with a control signal 270 indicating connecting the second terminal 303-2 to the first terminal 303-1 and connecting the second terminal 304-2 to the first terminal 304-1, and providing the control circuit 232 with a control signal 272 indicating connecting the first terminal 342-1 to the third terminal 342-3.

For example, the processor 201 may disable transmitting the signal 281 via the first antenna 291, while the signal 282 is transmitted via the second antenna 292 based on a voltage from the first power supply circuit 101 and the second power supply circuit 102. For example, the processor 201 may disable transmitting the signal 281 via the first antenna 291, by ceasing (or refraining from) obtaining (or generating) the signal 281 or ceasing (or refraining from ) providing the signal 281 to the PA 221. For example, the processor 201 may disable transmitting the signal 281 via the first antenna 291, by providing the control circuit 231 with a control signal 271 indicating disabling the PA 221.

For example, when the electronic device 200 further includes the third FEM 213, the fourth FEM 214, the third antenna 293, and the fourth antenna 294, the processor 201 may disable transmitting the signal 283 via the third antenna 293 using the third FEM 213 and transmitting the signal 284 via the fourth antenna 294 using the fourth FEM 214, while the signal 282 is transmitted via the second antenna 292 based on the voltage from both the first power supply circuit 101 and the second power supply circuit 102. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disconnecting the first terminal 243-1 of the switch 243 from the third terminal 243-3 of the switch 243 and disconnecting the second terminal 243-2 of the switch 243 from the third terminal 243-3 of the switch 243. For example, the processor 201 may disable transmitting the signal 283 via the third antenna 293 using the third FEM 213 and transmitting the signal 284 via the fourth antenna 294 using the fourth FEM 214, based on providing the control circuit 233 with the control signal 273 indicating disabling the PA 223 and providing the control circuit 234 with the control signal 274 indicating disabling the PA 224. For example, the processor 201 may disable transmitting the signal 283 via the third antenna 293 using the third FEM 213 and transmitting the signal 284 via the fourth antenna 294 using the fourth FEM 214, by refraining from obtaining each of the signal 283 and the signal 284 or refraining from providing each of the signal 283 and the signal 284 to each of the third FEM 213 and the fourth FEM 214.

As a non-limiting example, a Tx power of the signal 282 transmitted via the second antenna 292 using both the first power supply circuit 101 and the second power supply circuit 102 may correspond to a power class 2 (e.g., 26 dBm (tolerance: +2/-3 dBm) or a power class 1.5 (e.g., 29 dBm (tolerance: +2/-3 dBm) of the communication standard. For example, since an intensity of a current used (or consumed) to obtain a Tx power corresponding to the power class 2 or the power class 1.5 is higher than a maximum intensity of a current capable of being obtained from a (or any one of) power supply circuit from among the first power supply circuit 101 and the second power supply circuit 102. The processor 201 may connect both the first power supply circuit 101 and the second power supply circuit 102 in parallel to the PA 222 using the switch 303, the switch 304, and the switch 342.

As a non-limiting example, when the signal 282 is transmitted to a satellite via the second antenna 292 using both the first power supply circuit 101 and the second power supply circuit 102, an intensity of a current used to obtain a Tx power of the signal 282 may be higher than the maximum intensity of the current capable of being obtained from a (or any one of) power supply circuit from among the first power supply circuit 101 and the second power supply circuit 102. For example, the processor 201 may electrically connect both the first power supply circuit 101 and the second power supply circuit 102 in parallel to the PA 222 using the switch 303, the switch 304, and the switch 342 to obtain the Tx power of the signal 282. For example, the electronic device 300 may transmit a signal with a higher Tx power, by including the power supply module 100-1 including the switch 303 and the switch 304, and the second FEM 212 including the switch 342.

As described above, the electronic device 300 may provide transmission according to a double connection, transmission of a signal with a higher Tx power, and diversity of Tx power, using the power supply module 100-2 including the switch 303 and the switch 304 and the second FEM 212 including the switch 342.

FIG. 4 illustrates an exemplary electronic device comprising a power supply module comprising a double pole double throw (DPDT) switch and power supply circuits.

Referring to FIG. 4, an electronic device 400 may include a power supply module 100-3 including a first pin 106, a second pin 107, a first power supply circuit 101, a second power supply circuit 102, and a switch 403 that is the switch module 103, instead of a power supply module 100-1 including a switch 203, a first pin 106, a second pin 107, a first power supply circuit 101, and a second power supply circuit 102, and a power supply module 100-2 including a first pin 106, a second pin 107, a third pin 308, a first power supply circuit 101, s second power supply circuit 102, a switch 303, and a switch 304.

For example, the switch 403 may include a first terminal 403-1 connected to the first power supply module 101, a second terminal 403-2 connected to the second power supply module 102, a third terminal 403-3 connected to the first pin 106, and a fourth terminal 403-4 connected to the second pin 107.

For example, the processor 201 may control the power supply module 100-3 to disconnect a PA 221 from the second power supply circuit 102, in order to transmit a signal 281 via a first antenna 291 with a Tx power obtained using the PA 221 operating based on a voltage Vcc1 from the first power supply circuit 101. For example, the processor 201 may connect the PA 221 to the first power supply circuit 101 and disconnect the PA 221 from the second power supply circuit 102, based on providing the power supply module 100-3 with a control signal 270 indicating connecting the third terminal 403-3 to the first terminal 403-1 and disconnecting the third terminal 403-3 from the second terminal 403-2.

For example, the processor 201 may control the power supply module 100-3 to disconnect the PA 222 from the first power supply circuit 101, to transmit the signal 282 via a second antenna 292 with a Tx power obtained using the PA 222 operating based on a voltage Vcc2 from the second power supply circuit 102. For example, the processor 201 may disconnect the PA 222 from the first power supply circuit 101 and connect the PA 222 to the second power supply circuit 102, based on providing the power supply module 100-3 with the control signal 270 indicating disconnecting the fourth terminal 403-4 from the first terminal 403-1 and connecting the fourth terminal 403-4 to the second terminal 403-2.

For example, the signal 282 may be transmitted while the signal 281 is transmitted. For example, the electronic device 400 may support a double connection by including the power supply module 100-3 including the switch 403.

For example, the signal 284 may be transmitted while the signal 281 is transmitted. For example, in order to transmit the signal 284 while the signal 281 is being transmitted, the processor 201 may provide the control circuit 233 with a control signal 273 indicating connecting the second terminal 243-2 of the switch 243 to the third terminal 243-3 of the switch 243 and disconnecting the first terminal 243-1 of the switch 243 from the third terminal 243-3 of the switch 243, and provide the power supply module 100-3 with a control signal 270 indicating connecting the fourth terminal 403-4 to the second terminal 403-2. For example, a voltage Vcc2 from the second power supply circuit 102 may be provided to a PA 224 via the switch 243 in a state of connecting the second terminal 243-2 of the switch 243 to the third terminal 243-3 of the switch 243 and disconnecting the first terminal 243-1 of the switch 243 from the third terminal 243-3 of the switch 243. For example, while the signal 281 is transmitted, the signal 284 may be transmitted via the fourth antenna 294 with a Tx power obtained using the PA 224 operating based on the voltage Vcc2 from the second power supply circuit 102. For example, transmitting the signal 282 may be disabled while the signal 281 and the signal 284 are transmitted.

For example, the signal 284 may be transmitted while the signal 282 is transmitted. For example, in order to transmit the signal 284 while the signal 282 is transmitted, the processor 201 may provide a control circuit 233 with the control signal 273 indicating connecting the first terminal 243-1 of the switch 243 to the third terminal 243-3 of the switch 243 and disconnecting the second terminal 243-2 of the switch 243 from the third terminal 243-3 of the switch 243, and provide the power supply module 100-3 with a control signal 270 indicating connecting the third terminal 403- to the first terminal 403-1. For example, the voltage Vcc1 from the first power supply circuit 101 may be provided to the PA 224 through the switch 243 in a state of connecting the first terminal 243-1 of the switch 243 to the third terminal 243-3 of the switch 243 and disconnecting the second terminal 243-2 of the switch 243 from the third terminal 243-3 of the switch 243. For example, while the signal 282 is transmitted, the signal 284 may be transmitted via the fourth antenna 294 with a Tx power obtained using the PA 224 operating based on the voltage Vcc1 from the first power supply circuit 102. For example, transmitting signal 281 may be disabled while the signal 282 and the signal 284 are transmitted.

For example, the processor 201 may control the power supply module 100-3 to connect the PA 222 to the first power supply circuit 101, in order to transmit the signal 282 with a Tx power obtained using the PA 222 operating based on the voltage Vcc1 from the first power supply circuit 101 from among the first power supply circuit 101 and the second power supply circuit 102, via the second antenna 292. For example, the processor 201 may electrically connect the PA 222 to the first power supply circuit 101, based on providing the power supply module 100-3 with the control signal 270 indicating connecting the fourth terminal 403-4 to the first terminal 403-1 and disconnecting the fourth terminal 403-4 from the second terminal 403-2.

For example, while the signal 282 is transmitted based on the voltage Vcc1 from the first power supply circuit 101, the processor 201 may transmit the signal 284, based on providing to the power supply module 100-3 with a control signal 270 further indicating connecting the third terminal 403-3 to the second terminal 403-2, and providing to the control circuit 233 with a control signal 273 indicating connecting the third terminal 243-3 to the first terminal 243-1 and disconnecting the third terminal 243-3 from the second terminal 243-2.

For example, the processor 201 may control the power supply module 100-3 to electrically connect the PA 221 to the second power supply circuit 102, in order to transmit the signal 281 via the first antenna 291 with a Tx power obtained using the PA 221 operating based on the voltage Vcc2 from the second power supply circuit 102 from among the first power supply circuit 101 and the second power supply circuit 102. For example, the processor 201 may connect the PA 221 to the second power supply circuit 102, based on providing the power supply module 100-3 with the control signal 270 indicating connecting the third terminal 403-3 to the second terminal 403-2 and disconnecting the third terminal 403-3 from the first terminal 403-1.

For example, while the signal 281 is transmitted based on the voltage Vcc2 from the second power supply circuit 102, the processor 201 may transmit the signal 284, based on providing the power supply module 100-3 with a control signal 270 further indicating connecting the fourth terminal 403-4 to the first terminal 403-1, and providing the control circuit 233 with the control signal 273 indicating connecting the third terminal 243-3 to the second terminal 243-2 and disconnecting the third terminal 243-3 from the first terminal 243-1.

For example, the processor 201 may control the power supply module 100-3 to connect the PA 222 to the first power supply circuit 101 and the second power supply circuit 102, in order to transmit the signal 282 with a Tx power obtained using the PA 222 operating based on the voltage Vcc1 from the first power supply circuit 101 and the voltage Vcc2 from the second power supply circuit 102 equal to the voltage Vcc1 (or a voltage from the first power supply circuit 101 and the second power supply circuit 102), via the second antenna 292. For example, the processor 201 may transmit the signal 282 based on providing the power supply module 100-3 with the control signal 270 indicating connecting the fourth terminal 403-4 to the first terminal 403-1 and connecting the fourth terminal 403-4 to the second terminal 403-2. For example, the transmission of the signal 281, the signal 283, and the signal 284 may be disabled while the signal 282 is transmitted based on the voltages from the first power supply circuit 101 and the second power supply circuit 102.

For example, the processor 201 may control the power supply module 100-3 to connect the PA 221 to the first power supply circuit 101 and the second power supply circuit 102, in order to transmit the signal 281 with a Tx power obtained using the PA 221 operating based on the voltage Vcc1 from the first power supply circuit 101 and the voltage Vcc2 from the second power supply circuit 102 equal to the voltage Vcc1 (or a voltage from the first power supply circuit 101 and the second power supply circuit 102), via the first antenna 291. For example, the processor 201 may transmit the signal 281 based on providing the power supply module 100-3 with the control signal 270 indicating connecting the third terminal 403-3 to the first terminal 403-1 and connecting the third terminal 403-3 to the second terminal 403-2. For example, the transmission of the signal 282, the signal 283, and the signal 284 may be disabled while the signals 281 are transmitted based on the voltages from the first power supply circuit 101 and the second power supply circuit 102.

As described above, the electronic device 400 may provide transmission according to a double connection, transmission of a signal with a higher Tx power, and diversity of Tx power, using the power supply module 100-3 including the switch 403.

The operations illustrated above may be executed by an electronic device of FIG. 5 below.

FIG. 5 is a block diagram illustrating an electronic device 501 in a network environment 500 according to various embodiments. Referring to FIG. 5, the electronic device 501 in the network environment 500 may communicate with an electronic device 502 via a first network 598 (e.g., a short-range wireless communication network), or at least one of an electronic device 504 or a server 508 via a second network 599 (e.g., a long-range wireless communication network). According to an embodiment, the electronic device 501 may communicate with the electronic device 504 via the server 508. According to an embodiment, the electronic device 501 may include a processor 520, memory 530, an input module 550, a sound output module 555, a display module 560, an audio module 570, a sensor module 576, an interface 577, a connecting terminal 578, a haptic module 579, a camera module 580, a power management module 588, a battery 589, a communication module 590, a subscriber identification module (SIM) 596, or an antenna module 597. In various embodiments, at least one of the components (e.g., the connecting terminal 578) may be omitted from the electronic device 501, or one or more other components may be added in the electronic device 501. In various embodiments, some of the components (e.g., the sensor module 576, the camera module 580, or the antenna module 597) may be implemented as a single component (e.g., the display module 560).

The processor 520 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 520 may execute, for example, software (e.g., a program 540) to control at least one other component (e.g., a hardware or software component) of the electronic device 501 coupled with the processor 520, and may perform various data processing or computation. According to an embodiment, as at least part of the data processing or computation, the processor 520 may store a command or data received from another component (e.g., the sensor module 576 or the communication module 590) in volatile memory 532, process the command or the data stored in the volatile memory 532, and store resulting data in non-volatile memory 534. According to an embodiment, the processor 520 may include a main processor 521 (e.g., a central processing unit (CPU) or an application processor (AP)), or an auxiliary processor 523 (e.g., a graphics processing unit (GPU), a neural processing unit (NPU), an image signal processor (ISP), a sensor hub processor, or a communication processor (CP)) that is operable independently from, or in conjunction with, the main processor 521. For example, when the electronic device 501 includes the main processor 521 and the auxiliary processor 523, the auxiliary processor 523 may be adapted to consume less power than the main processor 521, or to be specific to a specified function. The auxiliary processor 523 may be implemented as separate from, or as part of the main processor 521.

The auxiliary processor 523 may control at least some of functions or states related to at least one component (e.g., the display module 560, the sensor module 576, or the communication module 590) among the components of the electronic device 501, instead of the main processor 521 while the main processor 521 is in an inactive (e.g., sleep) state, or together with the main processor 521 while the main processor 521 is in an active state (e.g., executing an application). According to an embodiment, the auxiliary processor 523 (e.g., an image signal processor or a communication processor) may be implemented as part of another component (e.g., the camera module 580 or the communication module 590) functionally related to the auxiliary processor 523. According to an embodiment, the auxiliary processor 523 (e.g., the neural processing unit) may include a hardware structure specified for artificial intelligence model processing. An artificial intelligence model may be generated by machine learning. Such learning may be performed, e.g., by the electronic device 501 where the artificial intelligence is performed or via a separate server (e.g., the server 508). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 530 may store various data used by at least one component (e.g., the processor 520 or the sensor module 576) of the electronic device 501. The various data may include, for example, software (e.g., the program 540) and input data or output data for a command related thereto. The memory 530 may include the volatile memory 532 or the non-volatile memory 534.

The program 540 may be stored in the memory 530 as software, and may include, for example, an operating system (OS) 542, middleware 544, or an application 546.

The input module 550 may receive a command or data to be used by another component (e.g., the processor 520) of the electronic device 501, from the outside (e.g., a user) of the electronic device 501. The input module 550 may include, for example, a microphone, a mouse, a keyboard, a key (e.g., a button), or a digital pen (e.g., a stylus pen).

The sound output module 555 may output sound signals to the outside of the electronic device 501. The sound output module 555 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 560 may visually provide information to the outside (e.g., a user) of the electronic device 501. The display module 560 may include, for example, a display, a hologram device, or a projector and control circuitry to control a corresponding one of the display, hologram device, and projector. According to an embodiment, the display module 560 may include a touch sensor adapted to detect a touch, or a pressure sensor adapted to measure the intensity of force incurred by the touch.

The audio module 570 may convert a sound into an electrical signal and vice versa. According to an embodiment, the audio module 570 may obtain the sound via the input module 550, or output the sound via the sound output module 555 or a headphone of an external electronic device (e.g., an electronic device 502) directly (e.g., wiredly) or wirelessly coupled with the electronic device 501.

The sensor module 576 may detect an operational state (e.g., power or temperature) of the electronic device 501 or an environmental state (e.g., a state of a user) external to the electronic device 501, and then generate an electrical signal or data value corresponding to the detected state. According to an embodiment, the sensor module 576 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 577 may support one or more specified protocols to be used for the electronic device 501 to be coupled with the external electronic device (e.g., the electronic device 502) directly (e.g., wiredly) or wirelessly. According to an embodiment, the interface 577 may include, for example, a high definition multimedia interface (HDMI), a universal serial bus (USB) interface, a secure digital (SD) card interface, or an audio interface.

A connecting terminal 578 may include a connector via which the electronic device 501 may be physically connected with the external electronic device (e.g., the electronic device 502). According to an embodiment, the connecting terminal 578 may include, for example, a HDMI connector, a USB connector, a SD card connector, or an audio connector (e.g., a headphone connector).

The haptic module 579 may convert an electrical signal into a mechanical stimulus (e.g., a vibration or a movement) or electrical stimulus which may be recognized by a user via his tactile sensation or kinesthetic sensation. According to an embodiment, the haptic module 579 may include, for example, a motor, a piezoelectric element, or an electric stimulator.

The camera module 580 may capture a still image or moving images. According to an embodiment, the camera module 580 may include one or more lenses, image sensors, image signal processors, or flashes.

The power management module 588 may manage power supplied to the electronic device 501. According to an embodiment, the power management module 588 may be implemented as at least part of, for example, a power management integrated circuit (PMIC).

The battery 589 may supply power to at least one component of the electronic device 501. According to an embodiment, the battery 589 may include, for example, a primary cell which is not rechargeable, a secondary cell which is rechargeable, or a fuel cell.

The communication module 590 may support establishing a direct (e.g., wired) communication channel or a wireless communication channel between the electronic device 501 and the external electronic device (e.g., the electronic device 502, the electronic device 504, or the server 508) and performing communication via the established communication channel. The communication module 590 may include one or more communication processors that are operable independently from the processor 520 (e.g., the application processor (AP)) and supports a direct (e.g., wired) communication or a wireless communication. According to an embodiment, the communication module 590 may include a wireless communication module 592 (e.g., a cellular communication module, a short-range wireless communication module, or a global navigation satellite system (GNSS) communication module) or a wired communication module 594 (e.g., a local area network (LAN) communication module or a power line communication (PLC) module). A corresponding one of these communication modules may communicate with the external electronic device via the first network 598 (e.g., a short-range communication network, such as Bluetooth^{™}, wireless-fidelity (Wi-Fi) direct, or infrared data association (IrDA)) or the second network 599 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 592 may identify and authenticate the electronic device 501 in a communication network, such as the first network 598 or the second network 599, using subscriber information (e.g., international mobile subscriber identity (IMSI)) stored in the subscriber identification module 596.

The wireless communication module 592 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 592 may support a high-frequency band (e.g., the mmWave band) to achieve, e.g., a high data transmission rate. The wireless communication module 592 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 592 may support various requirements specified in the electronic device 501, an external electronic device (e.g., the electronic device 504), or a network system (e.g., the second network 599). According to an embodiment, the wireless communication module 592 may support a peak data rate (e.g., 20Gbps or more) for implementing eMBB, loss coverage (e.g., 564dB or less) for implementing mMTC, or U-plane latency (e.g., 0.5ms or less for each of downlink (DL) and uplink (UL), or a round trip of 5ms or less) for implementing URLLC.

The antenna module 597 may transmit or receive a signal or power to or from the outside (e.g., the external electronic device) of the electronic device 501. According to an embodiment, the antenna module 597 may include an antenna including a radiating element including a conductive material or a conductive pattern formed in or on a substrate (e.g., a printed circuit board (PCB)). According to an embodiment, the antenna module 597 may include a plurality of antennas (e.g., array antennas). In such a case, at least one antenna appropriate for a communication scheme used in the communication network, such as the first network 598 or the second network 599, may be selected, for example, by the communication module 590 (e.g., the wireless communication module 592) from the plurality of antennas. The signal or the power may then be transmitted or received between the communication module 590 and the external electronic device via the selected at least one antenna. According to an embodiment, another component (e.g., a radio frequency integrated circuit (RFIC)) other than the radiating element may be additionally formed as part of the antenna module 597.

According to various embodiments, the antenna module 597 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 501 and the external electronic device 504 via the server 508 coupled with the second network 599. Each of the electronic devices 502 or 504 may be a device of a same type as, or a different type, from the electronic device 501. According to an embodiment, all or some of operations to be executed at the electronic device 501 may be executed at one or more of the external electronic devices 502, 504, or 508. For example, if the electronic device 501 should perform a function or a service automatically, or in response to a request from a user or another device, the electronic device 501, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 501. The electronic device 501 may provide the outcome, with or without further processing of the outcome, as at least part of a reply to the request. To that end, a cloud computing, distributed computing, mobile edge computing (MEC), or client-server computing technology may be used, for example. The electronic device 501 may provide ultra low-latency services using, e.g., distributed computing or mobile edge computing. In an embodiment, the external electronic device 504 may include an internet-of-things (IoT) device. The server 508 may be an intelligent server using machine learning and/or a neural network. According to an embodiment, the external electronic device 504 or the server 508 may be included in the second network 599. The electronic device 501 may be applied to intelligent services (e.g., smart home, smart city, smart car, or healthcare) based on 5G communication technology or IoT-related technology.

As described above, an electronic device according to an example embodiment, may comprise: a first antenna, a second antenna, a power supply module including a first power supply circuit and a second power supply circuit, a first front end module (FEM) including a power amplifier (PA) connected to the first power supply circuit and connectable to the second power supply circuit, a second FEM 212 including a PA connected to the second power supply circuit and connectable to the first power supply circuit, and at least one processor, comprising processing circuitry, individually and/or collectively, configured to control the power supply module to: disconnect the PA in the first FEM from the second power supply circuit to transmit a signal, with a transmit (Tx) power obtained using the PA in the first FEM operating based on a voltage from the first power supply circuit, via the first antenna; disconnect the PA in the second FEM from the first power supply circuit to transmit a signal, with a Tx power obtained using the PA in the second FEM operating based on a voltage from the second power supply circuit, via the second antenna; and connect the PA in the second FEM to the first power supply circuit to transmit a signal, with a Tx power obtained using the PA in the second FEM operating based on a voltage from the second power supply circuit from among the first power supply circuit and the second power supply circuit, via the second antenna.

For example, a connection between the PA 221 in the first FEM 211 and the first power supply circuit 101 and a connection between the PA 222 in the second FEM 212 and the second power supply circuit 102 may be maintained independently of whether the PA 222 in the second FEM 212 is connected to the first power supply circuit 101.

For example, at least one processor, individually and/or collectively, may be configured to control the power supply module to disable transmitting a signal via the first antenna using the PA in the first FEM, while the PA in the second FEM is connected to the first power supply circuit.

For example, the second power supply circuit 102 may be disabled while the signal is transmitted via the second antenna 292 with the Tx power obtained using the PA 222 in the second FEM 212 operating based on the voltage from the first power supply circuit 101 from among the first power supply circuit 101 and the second power supply circuit 102.

For example, at least one processor, individually and/or collectively, may be configured to control the power supply module to connect the PA in the first FEM to the second power supply circuit to transmit a signal, with a Tx power obtained using the PA in the first FEM operating based on a voltage from the second power supply circuit from among the first power supply circuit and the second power supply circuit, via the first antenna.

For example, at least one processor, individually and/or collectively, may be configured to disable transmitting a signal via the second antenna using the PA in the second FEM, while the PA in the first FEM connected to the second power supply circuit.

For example, the first power supply circuit 101 may be disabled while the signal is transmitted with the Tx power obtained using the PA 221 in the first FEM 211 operating based on the voltage from the second power supply circuit 102 from among the first power supply circuit 101 and the second power supply circuit 102 via the first antenna 291.

For example, the PA 221 in the first FEM 211 may be connected to the second power supply circuit 102 while the PA 222 in the second FEM 212 is connected to the first power supply circuit 101.

For example, at least one processor, individually and/or collectively, may be configured to control the power supply module to connect the PA in the second FEM to both the first power supply circuit and the second power supply circuit to transmit a signal, with a Tx power obtained using the PA in the second FEM operating based on a voltage from both the first power supply circuit and the second power supply circuit, via the second antenna.

For example, at least one processor, individually and/or collectively, may be configured to disable transmitting a signal via the first antenna using the PA in the first FEM, while the signal is transmitted via the second antenna with the Tx power obtained using the PA in the second FEM operating based on the voltage from both the first power supply circuit and the second power supply circuit.

For example, at least one processor, individually and/or collectively, may be configured to control the power supply module to connect the PA in the first FEM to both the first power supply circuit and the second power supply circuit to transmit a signal, with a Tx power obtained using the PA in the first FEM operating based on a voltage from both the first power supply circuit and the second power supply circuit, via the first antenna.

For example, at least one processor, individually and/or collectively, may be configured to disable transmitting a signal via the second antenna using the PA in the second FEM, while the signal is transmitted via the first antenna with the Tx power obtained using the PA in the first FEM operating based on the voltage from both the first power supply circuit and the second power supply circuit.

For example, the power supply module may include a first pin connected to the PA in the first FEM, a second pin connected to the PA in the second FEM, and a switch including a first terminal connected to a first path from the first power supply circuit to the first pin and a second terminal connected to a second path from the second power supply circuit to the second pin. For example, at least one processor, individually and/or collectively, may be configured to control the power supply module to: control the switch to disconnect the first terminal from the second terminal for disconnecting the PA in the first FEM from the second power supply circuit and disconnecting the PA in the second FEM from the first power supply circuit; and control the switch to connect the first terminal to the second terminal for connecting the PA in the second FEM to the first power supply circuit.

For example, the power supply module may include a first pin connected to the PA in the first FEM, a second pin connected to the PA in the second FEM, and a switch including a first terminal connected to the first power supply circuit, a second terminal connected to the second power supply circuit, a third terminal connected to the first pin, and a fourth terminal connected to the second pin. For example, at least one processor, individually and/or collectively, may be configured to control the power supply module to control the the switch to connect the third terminal to the first terminal and disconnect the third terminal from the second terminal for disconnecting the PA in the first FEM 211 from the second power supply circuit and connecting the PA in the first FEM to the first power supply circuit; control the switch to disconnect the fourth terminal from the first terminal and connect the fourth terminal to the second terminal for disconnecting the PA in the second FEM from the first power supply circuit and connecting the PA in the second FEM to the second power supply circuit ; and control the power supply module, based on controlling the switch to connect the fourth terminal to the first terminal for connecting the PA in the second FEM to the first power supply circuit.

For example, the first power supply circuit 101 may support both providing a voltage based on an envelope tracking (ET) and providing a voltage based on an average power tracking (APT). For example, the second power supply circuit 102 may support providing a voltage based on the APT from among the ET and the APT.

For example, a bandwidth of a signal transmitted using the first power supply circuit 101 may be wider than a bandwidth of a signal transmitted using the second power supply circuit 102.

For example, a maximum Tx power capable of being obtained using the first power supply circuit 101 may be higher than a maximum Tx power capable of being obtained using the second power supply circuit 102.

For example, at least one processor, individually and/or collectively, may be configured to transmit, while the signal is transmitted with the Tx power obtained using the PA in the first FEM operating based on the voltage form the first power supply circuit via the first antenna, the signal with the Tx power obtained using the PA in the second FEM operating based on the voltage from the second power supply circuit via the second antenna, based on disconnecting the PA in the first FEM from the second power supply circuit and disconnecting the PA in the second FEM from the first power supply circuit.

As described above, according to an example embodiment, an electronic device may comprise: a first antenna, a second antenna, a power supply module including a first power supply circuit and a second power supply circuit, a first front end module (FEM) including a power amplifier (PA) connected to the first power supply circuit and connectable to the second power supply circuit, a second FEM including a PA connected to the second power supply circuit and connectable to the first power supply circuit, and at least one processor, comprising processing circuitry, individually and/or collectively configured to: transmit, by enabling the first power supply circuit connected to the PA in the first FEM and disconnected from the PA in the second FEM and enabling the second power supply connected to the PA in the second FEM and disconnected from the PA in the first FEM, a signal via the second antenna using the PA in the second FEM, while a signal is transmitted via the first antenna using the PA in the first FEM ; and transmit, by enabling the first power supply circuit connected to the PA in the first FEM and connected to the PA in the second FEM and disabling the second power supply circuit connected to the PA in the first FEM and connected to the PA in the second FEM, a signal via the second antenna using the PA in the second FEM.

For example, at least one processor, individually and/or collectively, may be configured to: transmit, by disabling the first power supply circuit connected to the PA in the first FEM and connected to the PA in the second FEM and enabling the second power supply circuit connected to the PA in the first FEM and connected to the PA in the second FEM, a signal via the first antenna using the PA in the first FEM.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 540) including one or more instructions that are stored in a storage medium (e.g., internal memory 536 or external memory 538) that is readable by a machine (e.g., the electronic device 501). For example, a processor (e.g., the processor 520) of the machine (e.g., the electronic device 501) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from full scope of the disclosure, including the appended claims and their equivalents. It will also be understood that any of the embodiment(s) described herein may be used in conjunction with any other embodiment(s) described herein.

## Claims

1. An electronic device comprising:
memory, storing instructions, comprising one or more storage mediums;
a first antenna;
a second antenna;
power supply circuitry including a first power supply circuit and a second power supply circuit;
a first front end module (FEM) including a power amplifier (PA) connected to the first power supply circuit and connectable to the second power supply circuit;
a second FEM including a PA connected to the second power supply circuit and connectable to the first power supply circuit; and
at least one processor comprising, comprising processing circuitry,
wherein the instructions, when executed by the at least one processor, individually or collectively, cause the electronic device to:
control the power supply circuitry to disconnect the PA in the first FEM from the second power supply circuit to transmit a signal, with a transmit (Tx) power obtained using the PA in the first FEM operating based on a voltage from the first power supply circuit, via the first antenna;
control the power supply circuitry to disconnect the PA in the second FEM from the first power supply circuit to transmit a signal, with a Tx power obtained using the PA in the second FEM operating based on a voltage from the second power supply circuit, via the second antenna; and
control the power supply circuitry to connect the PA in the second FEM to the first power supply circuit to transmit a signal, with a Tx power obtained using the PA in the second FEM operating based on a voltage from the second power supply circuit from among the first power supply circuit and the second power supply circuit, via the second antenna.

2. The electronic device of claim 1, wherein a connection between the PA in the first FEM and the first power supply circuit and a connection between the PA in the second FEM and the second power supply circuit are configured to be maintained independently of whether the PA in the second FEM is connected to the first power supply circuit.

3. The electronic device of claim 2, wherein the instructions, when executed by the at least one processor, individually or collectively, cause the electronic device to:
disable transmitting a signal via the first antenna using the PA in the first FEM, while the PA in the second FEM is connected to the first power supply circuit.

4. The electronic device of claim 3, wherein the second power supply circuit is configured to be disabled while the signal is transmitted via the second antenna with the Tx power obtained using the PA in the second FEM operating based on the voltage from the first power supply circuit from among the first power supply circuit and the second power supply circuit.

5. The electronic device of claim 1, wherein the instructions, when executed by the at least one processor, individually or collectively, cause the electronic device to:
control the power supply circuitry to connect the PA in the first FEM to the second power supply circuit to transmit a signal, with a Tx power obtained using the PA in the first FEM operating based on a voltage from the second power supply circuit from among the first power supply circuit and the second power supply circuit, via the first antenna.

6. The electronic device of claim 5, wherein the instructions, when executed by the at least one processor, individually or collectively, cause the electronic device to:
disable transmitting a signal via the second antenna using the PA in the second FEM, while the PA in the first FEM is connected to the second power supply circuit.

7. The electronic device of claim 6, wherein the first power supply circuit is configured to be disabled while the signal is transmitted with the Tx power obtained using the PA in the first FEM operating based on the voltage from the second power supply circuit from among the first power supply circuit and the second power supply circuit via the first antenna.

8. The electronic device of claim 1, wherein the PA in the first FEM is connected to the second power supply circuit while the PA in the second FEM is connected to the first power supply circuit.

9. The electronic device of claim 1, wherein the instructions, when executed by the at least one processor, individually or collectively, cause the electronic device to:
control the power supply circuitry to connect the PA in the second FEM to both the first power supply circuit and the second power supply circuit to transmit a signal, with a Tx power obtained using the PA in the second FEM operating based on a voltage from both the first power supply circuit and the second power supply circuit, via the second antenna.

10. The electronic device of claim 9, wherein the instructions, when executed by the at least one processor, individually or collectively, cause the electronic device to:
disable transmitting a signal via the first antenna using the PA in the first FEM, while the signal is transmitted via the second antenna with the Tx power obtained using the PA in the second FEM operating based on the voltage from both the first power supply circuit and the second power supply circuit.

11. The electronic device of claim 1, wherein the instructions, when executed by the at least one processor, individually or collectively, cause the electronic device to:
control the power supply circuitry to connect the PA in the first FEM to both the first power supply circuit and the second power supply circuit to transmit a signal, with a Tx power obtained using the PA in the first FEM operating based on a voltage from both the first power supply circuit and the second power supply circuit, via the first antenna.

12. The electronic device of claim 11, wherein the instructions, when executed by the at least one processor, individually or collectively, cause the electronic device to:
disable transmitting a signal via the second antenna using the PA in the second FEM, while the signal is transmitted via the first antenna with the Tx power obtained using the PA in the first FEM operating based on the voltage from both the first power supply circuit and the second power supply circuit.

13. The electronic device of claim 1, wherein the power supply circuitry includes:
a first pin connected to the PA in the first FEM;
a second pin connected to the PA in the second FEM; and
a switch including a first terminal connected to a first path from the first power supply circuit to the first pin and a second terminal connected to a second path from the second power supply circuit to the second pin, and
wherein the instructions, when executed by the at least one processor, individually or collectively, cause the electronic device to:
control the power supply circuitry to control the switch to disconnect the first terminal from the second terminal for disconnecting the PA in the first FEM from the second power supply circuit and disconnecting the PA in the second FEM from the first power supply circuit; and
control the power supply circuitry to control the switch to connect the first terminal to the second terminal for connecting the PA in the second FEM to the first power supply circuit.

14. The electronic device of claim 1, wherein the power supply circuitry includes:
a first pin connected to the PA in the first FEM;
a second pin connected to the PA in the second FEM; and
a switch including a first terminal connected to the first power supply circuit, a second terminal connected to the second power supply circuit, a third terminal connected to the first pin, and a fourth terminal connected to the second pin, and
wherein the instructions, when executed by the at least one processor, individually or collectively, cause the electronic device to:
control the power supply circuitry to control the switch to connect the third terminal to the first terminal and disconnect the third terminal from the second terminal for disconnecting the PA in the first FEM from the second power supply circuit and connecting the PA in the first FEM to the first power supply circuit;
control the power supply circuitry to control the switch to disconnect the fourth terminal from the first terminal and connect the fourth terminal to the second terminal for disconnecting the PA in the second FEM from the first power supply circuit and connecting the PA in the second FEM to the second power supply circuit; and
control the power supply circuitry, based on controlling the switch to connect the fourth terminal to the first terminal for connecting the PA in the second FEM to the first power supply circuit.

15. The electronic device of claim 1, wherein the first power supply circuit is configured to support both providing a voltage based on envelope tracking (ET) and providing a voltage based on average power tracking (APT), and
wherein the second power supply circuit is configured to support providing a voltage based on the APT from among the ET and the APT.
